# EUROPEAN PATENT APPLICATION

(11) **EP 4 607 945 A1**
(43) Date of publication of application: **27.08.2025**
(21) Application number: 23879026.5
(22) Date of filing: 13.10.2023
(51) Int. Cl.: H04N 25/40, H04N 25/76, H04N 23/55

(54) **IMAGE SENSOR, CAMERA MODULE AND ELECTRONIC DEVICE**

(30) Priority: 19.10.2022 CN 202211279686
(71) Applicant: Vivo Mobile Communication Co., Ltd., Dongguan, Guangdong 523863 (CN)
(72) Inventor: XU, Jingxian, Dongguan, Guangdong 523863 (CN); TONG, Hui, Dongguan, Guangdong 523863 (CN)
(74) Representative: Murgitroyd & Company
(86) International application number: PCT/CN2023/124438
(87) International publication number: WO 2024/083035

(57) **Abstract**

This application discloses an image sensor, a camera module, an electronic device, and an image processing method, which relates to the field of image processing technologies. The image sensor includes a plurality of pixel units, where the pixel unit includes: a photosensitive layer located on a lower layer of the pixel unit and configured to collect an optical signal and convert the optical signal into an electrical signal; and a light-filtering layer located on an upper layer of the pixel unit, where the light-filtering layer includes a light-filtering region and a storage region, the light-filtering region is made of a light-transmitting material and at least partially overlaps with a projection of the photosensitive layer in an optical-axis direction, the storage region is made of a non-light-transmitting material and the storage region is used for storing a charged particle with a color, the charged particle is movable between the storage region and the light-filtering region, and the light-filtering region is used for causing light with the same color as the charged particle in the light-filtering region to penetrate the light-filtering region and enter the photosensitive layer on the lower layer.

## Description

### CROSS-REFERENCE TO RELATED APPLICATIONS

This application claims priority to Chinese Patent Application No. 202211279686.3, entitled "IMAGE SENSOR, CAMERA MODULE, AND ELECTRONIC DEVICE" filed with the China National Intellectual Property Administration on October 19, 2022, which is incorporated herein by reference in its entirety.

### TECHNICAL FIELD

This application relates to the field of image processing technologies, and specifically, to an image sensor, a camera module, and an electronic device.

### BACKGROUND

A conventional complementary metal oxide semiconductor (Complementary Metal Oxide Semiconductor, CMOS) image sensor mainly includes an upper-layer light filter and a photosensitive layer located below the light filter, to collect light with different colors. Natural light is formed by RGB three-color light, and becomes monochromatic light after passing through the light filter. The monochromatic light is received by the photosensitive layer below.

A pixel unit generally includes four identical photosensitive sensors and four light-filtering units that correspondingly filter corresponding colors of R, B, Gr, and Gb, to realize a pixel. A single photosensitive sensor can only receive light with one color, resulting in low utilization.

### SUMMARY

An objective of embodiments of this application is to provide an image sensor, a camera module, an electronic device, and an image processing method, which can resolve a problem of low utilization on a photosensitive sensor in a pixel structure of an existing image sensor.

According to a first aspect, an embodiment of this application provides an image sensor, including a plurality of pixel units, where the pixel unit includes: a photosensitive layer located on a lower layer of the pixel unit and configured to collect an optical signal and convert the optical signal into an electrical signal; and a light-filtering layer located on an upper layer of the pixel unit, where the light-filtering layer includes a light-filtering region and a storage region, the light-filtering region is made of a light-transmitting material and at least partially overlaps with a projection of the photosensitive layer in an optical-axis direction, the storage region is made of a non-light-transmitting material and the storage region is used for storing a charged particle with a color, the charged particle is movable between the storage region and the light-filtering region, and the light-filtering region is used for causing light with the same color as the charged particle in the light-filtering region to penetrate the light-filtering region and enter the photosensitive layer on the lower layer.

According to a second aspect, an embodiment of this application provides a camera module, including the image sensor according to the first aspect.

According to a third aspect, an embodiment of this application provides an electronic device, including the camera module according to the second aspect.

According to a fourth aspect, an embodiment of this application provides an image processing method, applied to an image processing apparatus including the image sensor according to the first aspect, the method including:
in a case that each light-filtering region 203 of the plurality of pixel units accommodates a charged particle with a first color, collecting, through each photosensitive layer of the plurality of pixel units, an optical signal with the first color penetrating the corresponding light-filtering region 203, and converting the optical signal with the first color into an electrical signal with the first color;
driving the charged particle with the first color to be moved from the light-filtering region 203 to the storage region, and controlling a charged particle with a second color stored in the storage region to be moved to the light-filtering region 203; and
collecting, through each photosensitive layer, an optical signal with the second color penetrating the corresponding light-filtering region 203, and converting the optical signal with the second color into an electrical signal with the second color, where
the first color and the second color are different colors.

In the embodiments of this application, through the image sensor in the foregoing embodiments, a single photosensitive sensor can collect light with different colors at different time, thereby implementing collection of image light information. In a case that an area of the photosensitive sensor is specific, more photosensitive sensors can be placed within a same area of the image sensor, and the single photosensitive sensor can realize a pixel, so that a quantity of pixels can be increased within the same area of the image sensor.

If the quantity of pixels does not need to be increased, the photosensitive sensor can be enlarged within the same area of the image sensor, thereby improving image quality.

### BRIEF DESCRIPTION OF THE DRAWINGS

FIG. 1 is a schematic structural diagram of a pixel unit of an image sensor according to an embodiment of this application;
FIG. 2 is a schematic diagram of an overall architecture of a pixel unit of an image sensor according to an embodiment of this application;
FIG. 3 is a schematic diagram of optical signal collection of a pixel unit of an image sensor according to an embodiment of this application; and
FIG. 4 is a flowchart of steps of an image processing method according to an embodiment of this application.

### DETAILED DESCRIPTION

The following clearly describes technical solutions in the embodiments of this application with reference to the accompanying drawings in the embodiments of this application. Apparently, the described embodiments are some of the embodiments of this application rather than all of the embodiments. All other embodiments derived by a person of ordinary skill in the art based on the embodiments of this application shall fall within the protection scope of this application.

In the specification and claims of this application, the terms "first", "second", and the like are used to distinguish similar objects, but are not used to describe a specific sequence or order. It may be understood that the data used in such a way is interchangeable in proper circumstances, so that the embodiments of this application described herein can be implemented in other sequences than the sequence illustrated or described herein, and the objects distinguished through "first", "second", and the like are generally of a same type and the number of the objects are not limited, for example, a first object may be one or more than one. In addition, "and/or" in this specification and the claims represents at least one of the connected objects, and a character "/" used herein generally indicates an "or" relationship between associated objects.

An image sensor, a camera module, an electronic device, and an image processing method according to the embodiments of this application are described in detail below with reference to the accompanying drawings through specific embodiments and application scenarios thereof.

An embodiment of this application provides a pixel structure, including: a photosensitive layer located on a lower layer of a pixel unit and configured to collect an optical signal and convert the optical signal into an electrical signal; and a light-filtering layer located on an upper layer of the pixel unit, where the light-filtering layer includes a light-filtering region and a storage region, the light-filtering region is made of a light-transmitting material and at least partially overlaps with a projection of the photosensitive layer in an optical-axis direction, the storage region is made of a non-light-transmitting material and the storage region is used for storing a charged particle with a color, the charged particle is movable between the storage region and the light-filtering region, and the light-filtering region is used for causing light with the same color as the charged particle in the light-filtering region to penetrate the light-filtering region and enter the photosensitive layer on the lower layer.

In this embodiment of this application, the pixel unit includes one photosensitive sensor and one corresponding light-filtering region. Through movably arranging charged particles with different colors in the light-filtering region, one pixel unit can implement collection of light with different colors, so that a pixel value of a corresponding pixel with each color can be obtained through subsequent processing.

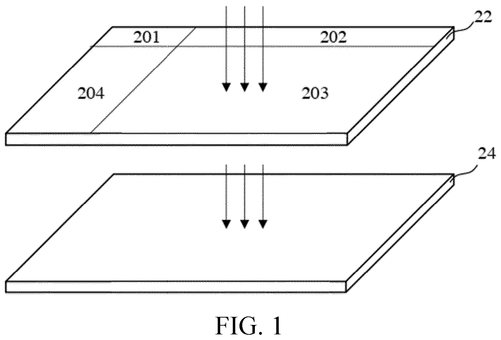

As shown in FIG. 1, a pixel unit includes a light-filtering layer 22 and a photosensitive layer 24. The light-filtering layer 22 and the photosensitive layer 24 are laminated in a top-to-bottom order. In addition, the light-filtering layer 22 at least partially overlaps with a projection of the photosensitive layer 24 in an optical-axis direction.

The light-filtering layer 22 located on an upper layer of the pixel unit includes a light-filtering region made of a light-transmitting material, and a storage region made of a non-light-transmitting material. The storage region is used for storing a charged particle with a color, for example, a red charged particle, a green charged particle, and/or a blue charged particle. A charged particle with a target color in the storage region may be moved to the light-filtering region.

A light-transmitting property of the light-filtering region may cause light with the same color as the charged particle with the target color moved to the light-filtering region to penetrate the light-filtering region and enter the photosensitive layer 24 on a lower layer. The photosensitive layer 24 collects an optical signal with the target color and converts the optical signal into an electrical signal. The target color is a color of the foregoing charged particle, namely, red, green, or blue. When the red charged particle in the storage region is moved to the light-filtering region, the light-filtering region may cause red light to penetrate the light-filtering region; when the green charged particle in the storage region is moved to the light-filtering region, the light-filtering region may cause green light to penetrate the light-filtering region; and when the blue charged particle in the storage region is moved to the light-filtering region, the light-filtering region may cause blue light to penetrate the light-filtering region.

Optionally, the image sensor further includes: a drive unit, configured to drive the charged particle to be moved between the storage region and the light-filtering region.

Optionally, the drive unit includes: a first control electrode arranged in the storage region; and
a second control electrode arranged in the light-filtering region, where the first control electrode is configured to drive the charged particle to be moved from the storage region to the light-filtering region, and the second control electrode is configured to drive the charged particle to be moved from the light-filtering region to the storage region.

The charged particle is a particle with a positive charge or a negative charge. Appropriate control electrodes may be respectively arranged in the storage region and the light-filtering region, and according to a principle that like charges repel and opposite charges attract, the red charged particle, the green charged particle, or the blue charged particle stored in the storage region is moved to the light-filtering region, for filtering of light with a corresponding color.

Optionally, the storage region includes a first storage sub-region 201 used for storing the red charged particle, a second storage sub-region 202 used for storing the green charged particle, and a third storage sub-region 204 used for storing the blue charged particle, where the first storage sub-region 201, the second storage sub-region 202, and the third storage sub-region 204 are distributed on a peripheral side of the light-filtering region. As shown in FIG. 1, the light-filtering layer 22 is divided into four regions, including one light-filtering region 203 and three storage regions 201, 202, and 203.

In the prior art, a light-filtering layer of a pixel unit includes four light-filtering units respectively configured to filter light with different colors including red, green, and blue. In this embodiment of this application, a pixel unit may filter light with different colors through one light-filtering region 203.

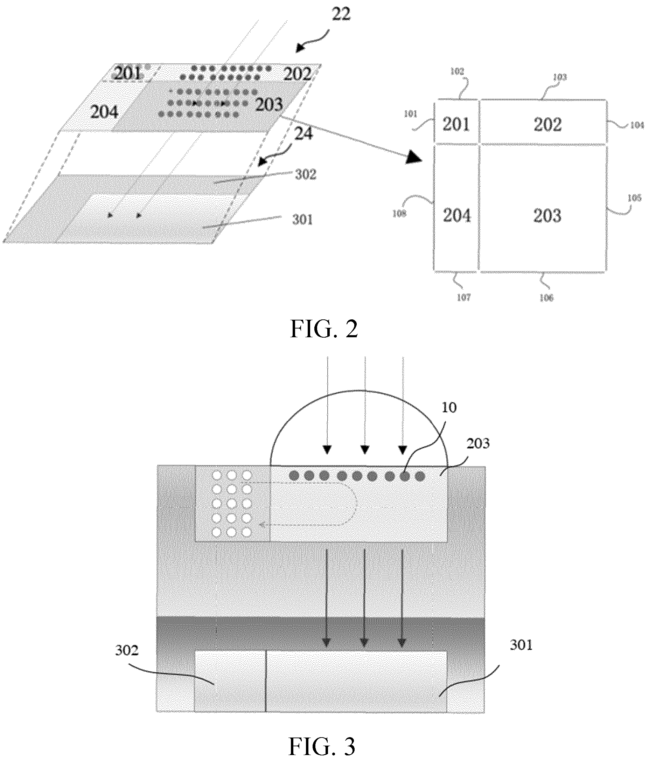

Referring to FIG. 2, a left side of FIG. 2 is a three-dimensional schematic diagram of the entire pixel unit, and a right side of FIG. 2 is a planar schematic diagram corresponding to the light-filtering layer 22 on the upper layer of the pixel unit.

The light-filtering region is made of the light-transmitting material, and may allow light with the same color as the charged particle in the light-filtering region to penetrate the light-filtering region. The storage region is made of the non-light-transmitting material, and the three storage regions are respectively used for storing the charged particles with three colors, namely, red, green, and blue, in a one-to-one correspondence. Light with the same color as the charged particle in the storage region cannot penetrate the light-filtering region.

Optionally, the storage region includes the first storage sub-region 201 used for storing the red charged particle, the second storage sub-region 202 used for storing the green charged particle, and the third storage sub-region 204 used for storing the blue charged particle, where the first storage sub-region 201, the second storage sub-region 202, and the third storage sub-region 204 are distributed on the peripheral side of the light-filtering region.

Referring to planar diagram examples on the right sides of FIG. 1 and FIG. 2, the light-filtering layer 22 includes the light-filtering region 203 and the three storage regions 201, 202, and 203. The first storage sub-region 201, the second storage sub-region 202, and the third storage sub-region 204 are distributed on the peripheral side of the light-filtering region 204. The first storage sub-region 201 has an edge adjacent to the second storage sub-region 202 and the third storage sub-region 204 separately. The light-filtering region 203 has an edge adjacent to the second storage sub-region 202 and the third storage sub-region 204 separately.

As described above, the first storage sub-region 201, the second storage sub-region 202, and the third storage sub-region 204 are respectively used for storing the charged particles with three colors, namely, red, green, and blue. There is no limitation on which color of the charged particle correspondingly stored in each storage region, as long as the three types of charged particles with different colors are respectively located in different storage regions. In other words, each storage region can store only charged particles with the same color.

As the name implies, the charged particle is a particle with a charge. The charged particle may be a particle with a positive charge or a negative charge. Certainly, the charged particles with the same color stored in each of the three storage regions need to simultaneously carry a same polarity of charge. In this embodiment of this application, the charged particle with a color may exist, for example, in an encapsulated form.

Because the charged particle itself carries a color, when the charged particle enters an environment of the light-filtering region made of the light-transmitting material, the color corresponding to the charged particle is displayed in the light-transmitting light-filtering region.

In the embodiment in FIG. 2, the four regions included in the light-filtering layer 22 are rectangles. However, this application is not limited to this specific embodiment. To improve utilization of the pixel unit, it may be ensured that the four regions of the light-filtering layer 22 have four edges and adjacent edges of two regions can be completely connected.

Optionally, the first storage sub-region 201, the second storage sub-region 202, the light-filtering region 203, and the third storage sub-region 204 are rectangles respectively. Alternatively, the first storage sub-region 201, the second storage sub-region 202, the light-filtering region 203, and the third storage sub-region 204 are rhombuses respectively.

Whether the charged particle is the charged particle stored in the first storage sub-region 201, the second storage sub-region 202, or the third storage sub-region 204, or the charged particle moved to the light-filtering region 203, a quantity and size of the charged particles in each region are the same. Alternatively, the size and quantity of the charged particles in different regions can be adjusted according to actual needs.

In this embodiment of this application, the charged particles with colors originally stored in the first storage sub-region 201, the second storage sub-region 202, and the third storage sub-region 204 need to be sequentially moved to the light-filtering region 203, so that the light-filtering region 203 transmits light with the same color as the charged particle with a color accommodated in the light-filtering region 203 to the photosensitive layer on the lower layer.

Movement of the charged particle may be implemented through arrangement of an electrode in each region. Optionally, the first control electrode includes: a first electrode 101 and a second electrode 102 arranged in the first storage sub-region 201; a third electrode 103 and fourth electrode 104 arranged in the second storage sub-region 202; and a seventh electrode 107 and an eighth electrode 108 arranged in the third storage sub-region 204; and the second control electrode includes: a fifth electrode 105 and a sixth electrode 106 arranged in the light-filtering region 203, where the first electrode 101 is opposite to the fourth electrode 104, the second electrode 102 is opposite to the seventh electrode 107, the third electrode 103 is opposite to the sixth electrode 106, the fifth electrode 105 is opposite to the eighth electrode 108, and two opposite electrodes have different polarities when powered on.

An electrode layout of each region included in the light-filtering layer, and a principle of movement of the charged particle among different regions through a corresponding electrode are described below with reference to FIG. 2. In the embodiments shown in the figure, an example in which each region is a rectangle is used for description. Each of the first storage sub-region 201, the second storage sub-region 202, the light-filtering region 203, and the third storage sub-region 204 is a rectangle with four edges.

The first electrode 101 and the second electrode 102 are arranged in the first storage sub-region 201, and are correspondingly arranged at corresponding locations of two edges of a periphery of the first storage sub-region 201. In other words, the two edges on which the first electrode 101 and the second electrode 102 are arranged are edges of the first storage sub-region 201 that are not adjacent to the adjacent second storage sub-region 202 and the third storage sub-region 204.

The third electrode 103 and the fourth electrode 104 are arranged in the second storage sub-region 202, and are correspondingly arranged at corresponding locations of two edges of a periphery of the second storage sub-region 202. In other words, the two edges on which the third electrode 103 and the fourth electrode 104 are arranged are edges of the second storage sub-region 202 that are not adjacent to the adjacent first storage sub-region 201 and the light-filtering region 203.

The fifth electrode 105 and the sixth electrode 106 are arranged in the light-filtering region 203, and are correspondingly arranged at corresponding locations of two edges of a periphery of the light-filtering region 203. In other words, the two edges on which the fifth electrode 105 and the sixth electrode 105 are arranged are edges of the light-filtering region 203 that are not adjacent to the adjacent second storage sub-region 202 and the third storage sub-region 204.

The seventh electrode 107 and the eighth electrode 108 are arranged in the third storage sub-region 204, and are correspondingly arranged at corresponding locations of two edges of a periphery of the third storage sub-region 204. In other words, the two edges on which the seventh electrode 107 and the eighth electrode 108 are arranged are edges of the third storage sub-region 204 that are not adjacent to the adjacent first storage sub-region 201 and the light-filtering region 203.

Correspondingly, the first electrode 101 of the first storage sub-region 201 is opposite to the fourth electrode 104 of the second storage sub-region 202, the second electrode 102 of the first storage sub-region 201 is opposite to the seventh electrode 107 of the third storage sub-region 204, the third electrode 103 of the second storage sub-region 202 is opposite to the sixth electrode 106 of the light-filtering region 203, the fifth electrode 105 of the light-filtering region 203 is opposite to the eighth electrode 108 of the third storage sub-region 204, and two opposite electrodes have different polarities when powered on.

As described above, the charged particle accommodated in each region carries a charge. Therefore, in a case that positive and negative charges are respectively applied to two electrodes arranged opposite to each other in two regions, the charged particle in one region can be driven into the other region based on a principle of movement of the charged particle in an electric field that like charges attract and opposite charges repel.

In an initial state, only the three storage regions accommodate the charged particles with colors, and there is no charged particle in the light-filtering region. For the foregoing four regions, polarities of opposite electrodes need to be set to enable the charged particle to be moved in a clockwise direction, to be moved from the second storage sub-region 202 to the light-filtering region 203, moved from the light-filtering region 203 to the third storage sub-region 204, moved from the third storage sub-region 204 to the first storage sub-region 201, and moved from the first storage sub-region 201 to the second storage sub-region 202.

Alternatively, polarities of opposite electrodes need to be set to enable the charged particle to be moved in an anticlockwise direction, to be moved from a fourth storage sub-region 204 to the light-filtering region 203, moved from the light-filtering region 203 to the second storage sub-region 202, moved from the second storage sub-region 202 to the first storage sub-region 201, and moved from the first storage sub-region 201 to the third storage sub-region 203.

Setting of the polarities of the opposite electrodes of each region is related to a polarity of a charge of the charged particle and a movement direction of the charged particle.

For example, the charged particle carries a positive charge, and the charged particle may be driven to be moved among the regions in a clockwise direction. If the charged particle with the positive charge is driven to be moved from the second storage sub-region 202 to the light-filtering region 203, a polarity of the third electrode 103 of the second storage sub-region 202 after being powered on is a positive charge, which is the same as the polarity of the charged particle, while a polarity of the sixth electrode 106 of the light-filtering region 203 is a negative charge, which is different from the polarity of the charged particle. In this way, a charged particle with a specific color with a positive charge currently stored in the second storage sub-region 202 may be quickly moved from the second storage sub-region 202 to the light-filtering region 203.

Similarly, if the charged particle with the positive charge is driven to be moved from the light-filtering region 203 to the third storage sub-region 204, a polarity of the fifth electrode 105 of the light-filtering region 203 after being powered on is a positive charge, which is the same as the polarity of the charged particle, while a polarity of the eighth electrode 108 of the third storage sub-region 204 is a negative charge, which is different from the polarity of the charged particle. In this way, a charged particle with a specific color with a positive charge currently accommodated in the light-filtering region 203 may be quickly moved from the light-filtering region 203 to the third storage sub-region 204. After the charged particle is moved to the third storage sub-region 204, the fifth electrode 105 and the eighth electrode 108 are controlled to be powered off.

If the charged particle with the positive charge is driven to be moved from the third storage sub-region 204 to the first storage sub-region 201, a polarity of the seventh electrode 107 of the third storage sub-region 204 after being powered on is a positive charge, which is the same as the polarity of the charged particle, while a polarity of the second electrode 102 of the first storage sub-region 201 is a negative charge, which is different from the polarity of the charged particle.

After the charge particle is moved to a corresponding region, the electrode is powered off, so that the charged particle moved to a target region can be kept staying in the region.

As described above, the light-filtering region may cause light with the same color as the charged particle in the light-filtering region to penetrate the light-filtering region and enter the photosensitive layer on the lower layer. In one period, the charged particle with one color is driven to be moved to the light-filtering region, so that the photosensitive layer collects an optical signal with a corresponding color and convert the optical signal into an electrical signal.

Through differentiation of three periods, the red charged particle, the green charged particle, and the blue charged particle may be sequentially moved to the light-filtering region, so that corresponding red light, green light, and blue light penetrate the light-filtering layer to enter the photosensitive layer below, and are separately collected and processed.

An example in which the light-filtering region 203 accommodates a red ink capsule in a current state is used below. If a blue ink capsule and a green ink capsule needs to be switched, the following steps needs to be performed.
1. Power on the fifth electrode 105 and the eighth electrode 108, control the red ink capsule in the light-filtering region 203 to enter the third storage sub-region 204, and power off the fifth electrode 105 and the eighth electrode 108.
2. Power on the third electrode 103 and the sixth electrode 106, and control the blue ink capsule in the second storage sub-region 202 to enter the light-filtering region 203. In this case, only blue light can penetrate the light-filtering region 203. Power off the third electrode 103 and the sixth electrode 106. In this way, the photosensitive layer below the light-filtering region 203 can collect the blue light.
3. Power on the first electrode 101 and the fourth electrode 104, control the green ink capsule to enter the second storage sub-region 202, and power off the first electrode 101 and the fourth electrode 104.
4. Power on the second electrode 102 and the seventh electrode 107, control the red ink capsule to enter the first storage sub-region 201, and power off the second electrode 102 and the seventh electrode 107.

Switching of a color collected by the photosensitive layer is completed in step 2, and step 3 and step 4 are preparation for next color switching. Next color switching happens between blue and green. By circulating the foregoing steps 1 to 4, the color switching can be completed. If more energy of a specific color needs to be collected, it requires only controlling the electrode to be powered off in a longer time.

The electrodes 101 to 108 in the figure are a plurality of control electrodes on the light-filtering layer. By periodically applying a voltage to the electrodes, the charged particles with different colors in the first storage sub-region 201, the second storage sub-region 202, the light-filtering region 203, and the third storage sub-region 204 are periodically driven to be moved, so that the light-filtering region 203 made of the light-transmitting material is filled with the charged particle with a color, and light with the same color as the charged particle is enabled to penetrate the light-filtering region. For example, if the light-filtering region 203 is filled with the red charged particle, the light-filtering region 203 can enable only the red light to penetrate the light-filtering region.

In an embodiment, optionally, the photosensitive layer includes a photosensitive element and a conversion circuit, where the photosensitive element is located below the light-filtering region, and is configured to collect an optical signal penetrating the light-filtering region; the conversion circuit is connected to the photosensitive element, and is configured to convert the optical signal collected by the photosensitive element into a corresponding electrical signal; and an area of the photosensitive element is greater than or equal to an area of the light-filtering region.

As shown in FIG. 2, the photosensitive layer 24 includes a photosensitive element 301 and a conversion circuit 302. The photosensitive element 301 is located directly below the light-filtering region 203, and the conversion circuit 302 is located on a peripheral side of the photosensitive element 301. The photosensitive element 301 is, for example, a photosensitive sensor.

In a pixel structure, an area of the photosensitive layer 22 is consistent with an area of the light-filtering layer 24, and an area of the light-filtering region 203 is consistent with an area of the photosensitive element 301. However, to enable more light with a color penetrating the light-filtering region 203 to be collected by the photosensitive element 301, the area of the photosensitive element 301 may be set to be slightly greater than the area of the light-filtering region 203.

As shown in FIG. 3, in a case that there is, for example, a red charged particle 10 moved in the light-filtering region 203, during photographing of a camera, RGB natural light first enters the light-filtering region 203 on the upper layer of the pixel unit, and through the red charged particle 10, red light in the natural light penetrates the light-filtering region 203 and enters the photosensitive element 301 of the light-filtering layer on the lower layer of the pixel unit. The photosensitive element 301 collects a red optical signal that enters, and obtains a corresponding red electrical signal through photoelectric conversion of the conversion circuit 302 connected around.

After collection of the red light is completed, according to a same method, green light and blue light may be sequentially moved to the light-filtering region 203, and in combination with the photosensitive element 301 and the conversion circuit 302, a corresponding green electrical signal and a corresponding blue electrical signal may be obtained. In this way, collection of natural light corresponding to one pixel may be implemented.

In this embodiment of this application, a single photosensitive sensor of the light-filtering layer may collect light with different colors penetrating the light-filtering region at different time to realize one pixel. Compared with that an existing COMS image sensor can realize one pixel by only collecting light with three colors by four photosensitive sensors, the pixel structure in this embodiment of this application can collect light with different colors through the single photosensitive sensor to realize one pixel, thereby improving utilization of the photosensitive sensor. In addition, an area of the photosensitive sensor can be only 1/4 of a total area of four photosensitive sensors included in one existing pixel unit. In this way, more photosensitive sensors can be placed with the same area of image sensor. Therefore, a quantity of pixels can be significantly increased, thereby improving image quality.

Optionally, in an embodiment, the area of the light-filtering region 203 an area of the storage region. In a case that the storage region includes three sub-regions, the area of the light-filtering region 203 is greater than an area of the first storage sub-region 201, an area of the second storage sub-region 202, and an area of the third storage sub-region 204 separately.

In this embodiment, if the area of the light-filtering region 203 is enlarged, more light with a color may penetrate the light-filtering region and enter the photosensitive layer below.

In a case that an area of the image sensor is unchanged and a quantity of pixels is unchanged, in other words, an area of one pixel unit in this embodiment of this application is the same as the area of four photosensitive sensors included by one existing pixel unit, by enlarging the area of the light-filtering region in this application, an area of a single photosensitive sensor of each pixel unit can be correspondingly enlarged. In this way, an amount of sensed light is greater, in other words, the photosensitive sensor may collect more light with a color, and correspondingly, the image quality is better. In addition, difficulty of a manufacturing process of a photosensitive sensor with greater area may be significantly reduced, and in general, manufacturing difficulty of the image sensor is lowered.

In a case that the area of the light-filtering region is different from the area of each of the other three storage regions, a same quantity and size of charged particles may be accommodated in a corresponding region by setting a thickness of each region to be different.

In a case that the storage region includes three sub-regions, optionally, the first storage sub-region 201, the second storage sub-region 202, the third storage sub-region 204, and the light-filtering region 203 have a same volume, and correspondingly accommodate charged particles with a same quantity and size separately. Alternatively, volumes of different storage sub-regions may be separately set based on a quantity and size of charged particles accommodated in the first storage sub-region 201.

In this way, areas of the three storage regions may be reduced, and the area of the light-filtering region may be enlarged, so that more light with a color penetrates the light-filtering region, and the photosensitive layer collects a greater amount of sensed light, thereby improving the image quality.

In the embodiments of this application, through the image sensor in the foregoing embodiments, a single photosensitive sensor can collect light with different colors at different time, thereby implementing collection of an image. In a case that an area of the photosensitive sensor is specific, more photosensitive sensors can be placed within a same area of the image sensor, and the single photosensitive sensor can realize a pixel, so that in a same chip manufacturing process, more photosensitive sensors can be placed within a same area of the image sensor, and a quantity of pixels can be increased.

If the quantity of pixels does not need to be increased, the photosensitive sensor can be enlarged within the same area of the image sensor, thereby improving image quality.

In addition, if the area of the image sensor is unchanged and the quantity of pixels is unchanged, a sensing unit in the single pixel structure of the image sensor can be enlarged, so that the amount of sensed light is increased, and the image quality is improved.

Optionally, an embodiment of this application further provides a camera module, including the image sensor according to any of the foregoing embodiments.

The camera module further includes: a circuit board, where the image sensor is electrically connected to the circuit board; and a lens, where the lens is arranged on a side of the image sensor away from the circuit board.

Optionally, an embodiment of this application further provides an electronic device, including the camera module according to any one of the foregoing embodiments.

It is to be noted that, the electronic device in this embodiment of this application includes a mobile electronic device and a non-mobile electronic device.

In addition, an embodiment of this application further provides an image processing method, applied to an image processing apparatus including the image sensor according to any one of the foregoing embodiments.

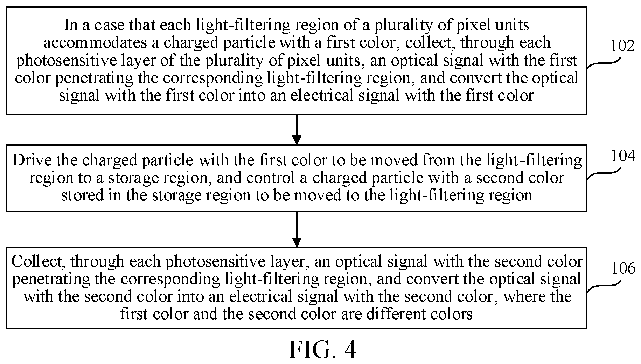

As shown in FIG. 4, the method includes the following steps.

Step 102: In a case that each light-filtering region of the plurality of pixel units accommodates a charged particle with a first color, collect, through each photosensitive layer of the plurality of pixel units, an optical signal with the first color penetrating the corresponding light-filtering region, and convert the optical signal with the first color into an electrical signal with the first color.

Step 104: Drive the charged particle with the first color to be moved from the light-filtering region to the storage region, and control a charged particle with a second color stored in the storage region to be moved to the light-filtering region 203.

Step 106: Collect, through each photosensitive layer, an optical signal with the second color penetrating the corresponding light-filtering region 203, and convert the optical signal with the second color into an electrical signal with the second color, where the first color and the second color are different colors.

The foregoing first color may be one of red, green, and blue. The second color is also one of red, green, and blue, and is different from the first color.

In actual application, colors corresponding to the first color and the second color may be preset. For example, first, a charged particle accommodated in the light-filtering region carries a red color by default. In other words, in a process of photographing an image, a red color is first collected through the pixel unit. After a time x, after the charged particle is moved, the charged particle accommodated in the light-filtering region carries a blue color by default. In other words, a blue color is subsequently collected through the pixel unit. After a time y, the charged particle accommodated in the light-filtering region carries a green color by default. In other words, a green color is subsequently collected through the pixel unit. In this way, collection of light with a color corresponding to each pixel of a photographed image is implemented. The image processing method provided in this embodiment of this application is performed by the image processing apparatus. The image processing apparatus includes the image sensor according to the foregoing embodiments of this application, and the image sensor according to the embodiments of this application includes the pixel structure according to any one of the foregoing embodiments.

An embodiment of this application further provides a readable storage medium, storing a program or instructions, where when the program or the instructions are executed by a processor, each process of the foregoing image processing method embodiments is implemented and the same technical effects can be achieved. Details are not described herein again to avoid repetition.

The foregoing processor is the processor in the electronic device described in the foregoing embodiment. The readable storage medium includes a computer-readable storage medium, for example, a computer read-only memory ROM, a random access memory RAM, a magnetic disk, or an optical disk.

An embodiment of this application additionally provides a chip, including a processor and a communication interface, where the communication interface is coupled to the processor, and the processor is configured to run a program or instructions to implement each process of the foregoing image processing method embodiments, and the same technical effects can be achieved. Details are not described herein again to avoid repetition.

It is to be understood that the chip mentioned in this embodiment of this application may also be referred to as a system-level chip, a system chip, a chip system, a system-on-a-chip chip, or the like.

An embodiment of this application provides a computer program product, where the program product is stored in a storage medium, and the program product is executed by at least one processor to implement each process of the foregoing image processing method embodiments, and the same technical effects can be achieved. Details are not described herein again to avoid repetition.

It is to be noted that, the term "comprise", "include" or any other variation thereof in this specification is intended to cover a non-exclusive inclusion, which specifies the presence of stated processes, methods, objects, or apparatuses, but does not preclude the presence or addition of one or more other processes, methods, objects, or apparatuses. Without more limitations, elements defined by the sentence "including one" does not exclude that there are still other same elements in the process, method, object, or apparatus. In addition, it is to be noted that, the scope of the method and apparatus in the embodiments of this application is not limited to performing the functions in the order shown or discussed, but may also include performing the functions in a substantially simultaneous manner or in a reverse order according to the functions involved, for example, the described method may be performed in a sequence different from the described order, and various steps may also be added, omitted, or combined. In addition, features described with reference to certain examples may be combined in other examples.

Through the description of the foregoing implementations, a person skilled in the art may clearly understand that the method according to the foregoing embodiments may be implemented by means of software and a necessary general hardware platform, and certainly, may also be implemented by hardware, but in many cases, the former manner is a better implementation. Based on such an understanding, the technical solutions of this application essentially or the part contributing to the prior art may be implemented in a form of a computer software product. The computer software product is stored in a storage medium (such as a ROM/RAM, a magnetic disk, or an optical disk) and includes several instructions for instructing a terminal (which may be a mobile phone, a computer, a server, a network device, or the like) to perform the methods described in the embodiments of this application.

The embodiments of this application are described above with reference to the accompanying drawings, but this application is not limited to the foregoing specific embodiments, which are merely illustrative rather than limited. Under the inspiration of this application, a person of ordinary skill in the art can make many forms without departing from the scope of this application and the protection of the claims, all of which fall within the protection of this application.

## Claims

1. An image sensor, comprising a plurality of pixel units, wherein the pixel unit comprises:
a photosensitive layer located on a lower layer of the pixel unit and configured to collect an optical signal and convert the optical signal into an electrical signal; and
a light-filtering layer located on an upper layer of the pixel unit, wherein the light-filtering layer comprises a light-filtering region and a storage region, the light-filtering region is made of a light-transmitting material and at least partially overlaps with a projection of the photosensitive layer in an optical-axis direction, the storage region is made of a non-light-transmitting material and the storage region is used for storing a charged particle with a color, the charged particle is movable between the storage region and the light-filtering region, and the light-filtering region is used for causing light with the same color as the charged particle in the light-filtering region to penetrate the light-filtering region and enter the photosensitive layer on the lower layer.

2. The image sensor according to claim 1, further comprising:
a drive unit, configured to drive the charged particle to be moved between the storage region and the light-filtering region.

3. The image sensor according to claim 2, wherein the drive unit comprises:
a first control electrode arranged in the storage region; and
a second control electrode arranged in the light-filtering region, wherein
the first control electrode is configured to drive the charged particle to be moved from the storage region to the light-filtering region, and the second control electrode is configured to drive the charged particle to be moved from the light-filtering region to the storage region.

4. The image sensor according to claim 3, wherein the storage region comprises a first storage sub-region used for storing a red charged particle, a second storage sub-region used for storing a green charged particle, and a third storage sub-region used for storing a blue charged particle, wherein
the first storage sub-region, the second storage sub-region, and the third storage sub-region are distributed on a peripheral side of the light-filtering region.

5. The image sensor according to claim 4, wherein the first control electrode comprises:
a first electrode and a second electrode arranged in the first storage sub-region;
a third electrode and a fourth electrode arranged in the second storage sub-region; and
a seventh electrode and an eighth electrode arranged in the third storage sub-region; and
the second control electrode comprises: a fifth electrode and a sixth electrode arranged in the light-filtering region, wherein
the first electrode, the second electrode, the third electrode, the fourth electrode, the fifth electrode, the sixth electrode, the seventh electrode, and the eighth electrode are respectively arranged on peripheral sides of corresponding regions that are not adjacent to other regions; and
the first electrode is opposite to the fourth electrode, the second electrode is opposite to the seventh electrode, the third electrode is opposite to the sixth electrode, the fifth electrode is opposite to the eighth electrode, and two opposite electrodes have different polarities when powered on.

6. The image sensor according to claim 1, wherein an area of the light-filtering region is greater than an area of the storage region.

7. The image sensor according to claim 4, wherein the first storage sub-region, the second storage sub-region, the third storage sub-region, and the light-filtering region have a same volume, and correspondingly accommodate charged particles with a same quantity and size separately.

8. The image sensor according to any one of claims 1 to 7, wherein the photosensitive layer comprises a photosensitive element and a conversion circuit, wherein
the photosensitive element is located below the light-filtering region, and is configured to collect the optical signal penetrating the light-filtering region;
the conversion circuit is connected to the photosensitive element, and is configured to convert the optical signal collected by the photosensitive element into the corresponding electrical signal; and
an area of the photosensitive element is greater than or equal to the area of the light-filtering region.

9. A camera module, comprising the image sensor according to any one of claims 1 to 8.

10. The camera module according to claim 9, wherein the camera module further comprises:
a circuit board, wherein the image sensor is electrically connected to the circuit board; and
a lens, wherein the lens is arranged on a side of the image sensor away from the circuit board.

11. An electronic device, comprising the camera module according to claim 9 or 10.

12. An image processing method, applied to an image processing apparatus comprising the image sensor according to any one of claims 1 to 8, the method comprising:
in a case that each light-filtering region of the plurality of pixel units accommodates a charged particle with a first color, collecting, through each photosensitive layer of the plurality of pixel units, an optical signal with the first color penetrating the corresponding light-filtering region, and converting the optical signal with the first color into an electrical signal with the first color;
driving the charged particle with the first color to be moved from the light-filtering region to the storage region, and controlling a charged particle with a second color stored in the storage region to be moved to the light-filtering region; and
collecting, through each photosensitive layer, an optical signal with the second color penetrating the corresponding light-filtering region, and converting the optical signal with the second color into an electrical signal with the second color, wherein
the first color and the second color are different colors.
